(19) Europäisches Patentamt
European Patent Office
Office européen des brevets

(11) Publication number: **0 136 108**
**B1**

# (12) EUROPEAN PATENT SPECIFICATION

(45) Date of publication of patent specification: **08.06.88**

(51) Int. Cl.[4]: **H 01 L 29/205**, H 01 L 29/72, H 01 L 29/80, H 01 L 47/00

(21) Application number: **84305925.4**

(22) Date of filing: **30.08.84**

## (54) Heterojunction semiconductor device.

(30) Priority: **31.08.83 JP 159800/83**

(43) Date of publication of application: **03.04.85 Bulletin 85/14**

(45) Publication of the grant of the patent: **08.06.88 Bulletin 88/23**

(84) Designated Contracting States: **DE FR GB IT NL**

(56) References cited:
**EP-A-0 046 422**
**EP-A-0 050 064**
**US-A-4 257 055**

**APPLIED PHYSICS LETTERS, vol. 40, No. 2, 15 January 1982, New York, USA; K.Y. CHENG et al. "Electron mobilities in modulation doped Ga0.47In0.53 As/Alo.48In0.52As heterojunctions grown by molecular beam epitaxy", pages 147-149**

**IEEE ELECTRON DEVICE LETTERS, vol. EDL-3, No. 12, December 1982, New York, USA; K. TABATABAIE-ALAVI et al. "Ion-implanted In0.53Ga0.47As/In0.52Al0.48As lateral PNP Transistors", pages 379-381**
**idem**

(73) Proprietor: **Inoue, Masataka**
**349 Kitanoda**
**Sakai-shi Osaka (JP)**

(72) Inventor: **Inoue, Masataka**
**349 Kitanoda**
**Sakai-shi Osaka (JP)**

(74) Representative: **Rackham, Stephen Neil et al**
**GILL JENNINGS & EVERY 53-64 Chancery Lane**
**London WC2A 1HN (GB)**

(56) References cited:

**IEEE ELECTRON DEVICE LETTERS, vol. EDL-3, No. 8, August 1982, New York, USA; C.Y. CHEN et al. "Short channel Ga0.47In0.53As/Al 0.48In0.52As selectively doped field effect transistors", pages 205-208**
**idem**

**APPLIED PHYSICS LETTERS, vol. 44, No. 3, 1 February 1984, New York, USA; B. WAKEFIELD et al. "Direct energy gap of Al1-xInxAs lattice matched to inP",**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

**EP 0 136 108 B1**

Courier Press, Leamington Spa, England.

**Description**

The present invention relates to a heterojunction semiconductor device and, more particularly, to a semiconductor device using InP/InAlAs heterojunction.

The junction of two semiconductors of different kinds, a heterojunction, is widely used in producing high speed devices and semiconductor lasers because it serves to form an electron storage layer or to capture carriers of the side of the low conductivity band of the hetero-interface by a discontinuity in the bottom of the conductive band. The characteristics of a heterojunction vary considerably depending upon the energy band structures (energy band gap and electron affinity) of the two semiconductors to be joined.

A typical heterojunction used previously in high speed devices is a GaAs/AlGaAs heterojunction which provides operations higher in speed than a GaAs MESFET (Schottky gate field effect transistor) but, on the other hand, has difficulty in achieving ballistic devices and high mobility active devices because carriers are easy to transit from Γ valley (main band) to L valley (sub band) in the GaAs of the active layer, thereby to cause an intervalley scattering accompanied by negative differential mobility in an electric field strength of approximately 3 KV/cm or higher.

According to the present invention these problems with conventional heterojunction devices are overcome by using an InP and $Al_xIn_{1-x}As$ heterojunction where x is approximately equal to 0.48.

According to one practical aspect of the present invention a field effect transistor comprising a substrate, two ohmic electrodes for a source and drain, and a Schottky electrode for a gate arranged between the two ohmic electrodes is characterised in that the substrate comprises semi-insulating InP, in that an undoped InP layer is present on the semi-insulating InP substrate, in that an $N^+$ type $In_{1-x}Al_xAs$ layer is present on the InP layer where x is approximately equal to 0.48; and in that the two ohmic electrodes are arranged in two spaced regions on the $n^+$ type $In_{1-x}Al_xAs$ layer.

According to another practical aspect of the present invention a semiconductor device comprising a substrate and ohmic electrodes on opposite sides of the substrate, is characterised in that the substrate comprises semi-insulating InP, in that single or multiple stacked layers of each of $Al_xIn_{1-x}As$ where x is approximately equal to 0.48 and InP are present on the semi-insulating InP substrate, and in that the ohmic electrodes are located on opposite sides of the layers.

According to a third practical aspect of the present invention a bipolar heterojunction transistor comprising:

a substrate of $n^+$ type;

an $n^-$ type collector layer on the $n^+$ type substrate;

a $p^+$ type base layer on the collector layer; and

an n type emitter layer disposed on the base layer, is characterised in that the substrate, the collector layer and the base layer comprise InP, and in that the emitter layer comprises $Al_xIn_{1-x}As$ where x is approximately equal to 0.48.

In the present invention, InP is used in place of GaAs. As shown in Figure 1, while GaAs and InP are similar to each other in energy band structure, the energy difference $\Delta E_{\Gamma L}$ of InP is 0.53 eV which is considerably higher than that of GaAs which is 0.31 eV. Therefore, the threshold field of InP at which a negative resistance appears is approximately three times as large as that of GaAs. Further, in the field strength dependency of electron velocity, as shown in Figure 2, the peak electron velocity is higher in InP than in GaAs. Now, to use InP as the active layer, that is the layer through which carriers actually move, the semiconductor which is to be joined with the InP must have a smaller electron affinity than that of InP and a larger forbidden gap than that of InP, and must be lattice-matched to InP. The ternary mixed crystal $Al_xIn_{1-x}As$ where x is substantially equal to 0.48 is a material satisfying these requirements. That is, the energy band gap of $Al_xIn_{1-x}As$ where x is substantially equal to 0.48, is 1.49 eV (InP's is 1.35 eV) and its lattice constant is 5.87 Å (0.587 nm) which is identical to that of InP. Further, in view of the facts that the heights of the Schottky barriers of Au/InP and

$$Au/In_{0.52}Al_{0.48}As$$

are 0.49 eV and 0.8 eV, respectively, and that the energy discontinuities at bottoms of the conductive bands of the heterojunctions of

$$In_{0.53}Ga_{0.47}As/InP$$

and

$$In_{0.52}Al_{0.48}As/In_{0.53}Ga_{0.47}As$$

are 200 meV and 300—600 meV, respectively, the energy discontinuity at the bottom of the conductive band of $In_{1-x}Al_xAs$/InP where x is substantially equal to 0.48 is considered to be approximately 300 meV.

Particular embodiments of the present invention will now be described with reference to the accompanying drawings; in which:-

Figure 1A is an energy band structure diagram for GaAs;

Figure 1B is an energy band structure diagram for InP;

Figure 2 is a diagram showing field strength dependency of the electron velocity of GaAs and InP;

Figure 3 is a sectional view of a modulation doped field effect transistor using the heterojunction in accordance with the present invention;

Figure 4 is an energy band structure diagram on the heterointerface of

$$InP/Al_xIn_{1-x}As$$

where x is substantially equal to 0.48;

Figure 5 is a sectional view showing the structure of a real space transfer type semiconductor device using the heterojunction in accordance with the present invention; and,

Figure 6 is a sectional view showing the structure of a bipolar heterojunction transistor including a heterojunction in accordance with the present invention.

Figure 3 shows the sectional structure of an embodiment of a modulation-doped Schottky gate field effect transistor according to the present invention. In the structure shown in Figure 3, an undoped InP layer 12, an undoped $Al_xIn_{1-x}As$ (x=0.48) layer 13 of 0—200 Å thickness, and an Si doped $1\times10^{18}$ 1/cm$^3$ $n^+$ type $Al_xIn_{1-x}As$ (x=0.48) layer 14 of 500—1000 Å thickness are formed sequentially by, for example, molecular beam epitaxial growth on a semi-insulating InP substrate 11, a Schottky gate electrode 15 of aluminum is disposed on said $n^+$ type $Al_xIn_{1-x}As$ layer 14, and ohmic electrodes 16 and 17 of AuGeNi are disposed on opposite sides, respectively, of said gate electrode 15. As shown in Fig. 4, electrons are stored on the InP side of the hetero-interface by the discontinuity at the bottom of the conductive band of InP and $Al_xIn_{1-x}As$ (x≒0.48). That is, since InP has large electron affinity, the electrons supplied by donors in the $n^+$ type $Al_xIn_{1-x}As$ (x≒0.48) layer are attracted toward InP side to form an electron storage layer there.

This electron storage layer contributes to electric conduction between the source and the drain. However, since the InP layer is not doped with impurities, ionized impurity diffusion is reduced. This effect is large enough particularly at low temperatures where ionized impurity scattering becomes dominant to obtain high electron mobility. Known as a conventional FET using the similar principle in which the doped region in which carriers are generated and the undoped region in which the carriers actually move are separated in space is one using GaAs/AlGaAs heterojunction. In the undoped GaAs active layer, however, negative differential mobility appears because the carriers transit from the Γ valley where the effective mass of the carriers is small to the L valley where the effective mass of the carriers is large. Recently, a FET using

$$In_{0.52}Al_{0.48}As/In_{0.53}Ga_{0.47}As$$

hetero-interface has been proposed. In this FET, however, the characteristics of low electric field mobility are not utilized effectively in high electric field because the threshold field in which negative resistance appears is as low as 3—4 KV/cm in InGaAs as in GaAs. Further, the influence of alloy scattering in

$$In_{0.53}Ga_{0.47}As$$

alloy crystal presents a problem in application in devices. In the FET according to the present invention using InP as the active layer, there is no problem of alloy scattering, and further, since InP has higher threshold electric field and higher peak electron velocity than GaAs, it applies a high voltage to thereby make high output and high speed operation possible.

Fig. 5 shows the sectional structure of an embodiment of a real space transfer type semiconductor device according to the present invention. In the structure shown in Fig. 5, an $Al_xIn_{1-x}As$ (x≒0.48) layer 22 and an InP layer 23 are alternately stacked in multiple of layers by growth on a semi-insulating InP substrate 21. While this embodiment is shown to be of a multiple of stacked layers structure of repeated heterojunction, it may be of a single stacked layers structure of a single heterojunction. Ohmic electrodes 24 and 25 are disposed substantially vertically on the hetero-interfaces, respectively. In the same manner as in the embodiment described with reference to Figs. 3 and 4, an electron storage layer is formed on the InP side of each hetero-interface. When an electric field is applied between the ohmic electrodes 24 and 25, the electrons in InP are accelerated into hot electrons and scattered in the $Al_xIn_{1-x}As$ layer before transited to the upper valley (L valley) in InP. In $Al_xIn_{1-x}As$, negative differential resistance is caused because the electron mobility is smaller in $Al_xIn_{1-x}As$ than in InP. Since the electron transition time is dependent upon the lateral length, operation in the higher frequencies than Gunn diode can be expected. Known as a conventional semiconductor device of this type is a device using GaAs-AlGaAs heterojunction. In this device, however, since the energy difference $\Delta E_{\Gamma L}$ between Γ valley and L valley is 0.31 eV which is relatively small, hot electrons are apt to transit to L valley before they are scattered in $Al_xGa_{1-x}As$. In this conventional transistor device, accordingly, a negative differential resistance was, if obtained, caused mostly by Gunn effect and the negative differential resistance purely by real space transfer was difficult to achieve. In contrast to this, in the device using InP/$Al_xIn_{1-x}As$ (x≒0.48) heterojunction according to the present invention, having a large (0.53 eV) energy difference $\Delta E_{\Gamma L}$ of InP, there is less possibility of occurrence of the phenomenon that hot electrons of InP transit to L valley before scattering in $Al_xIn_{1-x}As$, and, therefore, the negative differential resistance by pure real space transfer in high electric field is obtained. Further, the undoped InP layer 23 and the $n^+$ type $Al_xIn_{1-x}As$ (x≒0.48) layer 22 may be formed by modulation doping process to increase the electron mobility in InP.

Fig. 6 shows an embodiment of a bipolar heterojunction transistor according to the present invention. In the structure shown in Fig. 6, on an $n^+$ type InP substrate (n=$2\times10^{18}$ 1/cm$^3$) 31, there are disposed an $n^-$ type InP collector layer ($1\times10^{16}$ 1/cm$^3$) 32 of 0.5 µm thickness a $p^+$ type ($1\times10^{19}$ 1/cm$^3$) InP base layer 33 of 500 Å thickness, and n type ($2\times10^{17}$ 1/cm$^3$) $Al_xIn_{1-x}As$ (x≒0.48) emitter layer 34 of 0.2 µm thickness, and an $n^+$ type ($1\times10^{19}$ 1/cm$^3$) InP cap layer 35 of 0.2

μm thickness. The transistor of this structure has various advantages such, for example, that a large current density is obtained in the active layer of the collector, mutual conductance gm is large, fan out dependency is small, and operating amplitude is small. Further, other effects such as ballistic operation or overshoot effect of electron velocity are made possible by reducing the thickness of the base layer to sub-micron level.

In the conventional

$$GaAs/Al_xGa_{1-x}As$$

bipolar heterojunction transistor using GaAs as the base layer, the energy difference $\Delta E_{\Gamma L}$ between Γ valley and L valley is, as described hereinabove, relatively small and phonon scattering is easy to occur between the valleys.

In contrast to this, in the transistor according to the present invention using InP as the base layer, since the energy difference $\Delta F_{\Gamma L}$ between Γ valley and L valley is large, phonon scattering between the valleys is suppressed in the base region and ballistic operation or overshoot of electron velocity is easy to occur. For this reason an ultra-high speed transistor is accomplished.

As explained hereinabove, various devices using $InP/Al_xIn_{1-x}As$ ($x \fallingdotseq 0.48$) heterojunction according to the present invention have higher operation speed than conventional devices and are applicable to all the technical fields where FET, IC and Gunn diode are presently used. Therefore, the present invention provides a very high industrial applicability particularly in technical fields requiring high speed processing, such as CPU, memory and image processor of a computer. Further, when InP is used the operating voltage can be increased because the threshold electric field is high, therefore, the heterojunction according to the present invention is made applicable as a high output micro device.

**Claims**

1. A semiconductor device characterised by a heterojunction between a layer of InP and a layer of $Al_xIn_{1-x}As$ where x is approximately equal to 0.48.

2. A field effect transistor comprising a substrate (11), two ohmic electrodes (16, 17) for a source and drain, and a Schottky electrode (15) for a gate arranged between the two ohmic electrodes (16, 17) characterised in that the substrate (11) comprises semi-insulating InP, in that an undoped InP layer is present on the semi-insulating InP substrate, in that an $N^+$ type $In_{1-x}Al_xAs$ layer is present on the InP layer where x is approximately equal to 0.48; and in that the two ohmic electrodes (16, 17) are arranged in two spaced regions on the $n^+$ type $In_{1-x}Al_xAs$ layer.

3. A semiconductor device comprising a substrate (21) and ohmic electrodes (24, 25) on opposite sides of the substrate, characterised in that the substrate (21) comprises semi-insulating InP, in that single or multiple stacked layers of each of $Al_xIn_{1-x}As$ (22) where x is approximately equal to 0.48 and InP (23) are present on the semi-insulating InP substrate (21), and in that the ohmic electrodes (24, 25) are located on opposite sides of the layers (22, 23).

4. A bipolar heterojunction transistor comprising:

a substrate (31) of $n^+$ type;

an $n^-$ type collector layer (32) on the $n^+$ type substate (31);

a $p^+$ type base layer (33) on the collector layer (32); and,

an n type emitter layer (34) disposed on the base layer (33),

characterised in that the substrate (31), the collector layer (32) and the base layer (33) comprise InP, and in that the emitter layer (34) comprises $Al_xIn_{1-x}As$ where x is approximately equal to 0.48.

**Patentansprüche**

1. Halbleiterelement, dadurch gekennzeichnet, daß zwischen einer Schicht aus InP und einer Schicht aus $Al_xIn_{1-x}As$ eine Heteroübergangszone vorgesehen ist, wobei x einen Wert von ungefähr 0,48 aufweist.

2. Feldeffekttransistor mit einem Substrat (11), zwei die Quelle und den Abfluß bildenden Ohm'schen Elektroden (16, 17) sowie einer die Steuerelektrode bildenden Schottky-Elektrode (15), welche zwischen den beiden Ohm'schen Elektroden (16, 17) angeordnet ist, dadurch gekennzeichnet, daß das Substrat (11) aus einem halbisolierenden InP-Material besteht, auf welchem eine nicht dotierte InP-Schicht aufgebracht ist, auf der wiederum eine $N^+$-Schicht aus $In_{1-x}Al_xAs$ vorhanden ist, wobei x einen Wert von ungefähr 0,48 aufweist, und die beiden Ohm'schen Elektroden (16, 17) in einem gewissen Abstand auf der $n^+$ $In_{1-x}Al_xAs$-Schicht aufgebracht sind.

3. Halbleiterelement mit einem Substrat (21) und zwei Ohm'schen Elektroden (24, 25), welche auf gegenüberliegenden Seiten des Substrats angeordnet sind, dadurch gekennzeichnet, daß das Substrat (21) aus einem halbisolierenden InP-Material besteht, daß auf diesem InP-Substrat (21) eine einzelne oder mehrere übereinandergelagerte Schichten von jeweils $Al_xIn_{1-x}As$ (22) sowie InP (23) aufgebracht sind, wobei x einen Zahlenwert von ungefähr 0,48 aufweist, und daß an den gegenüberliegenden Seiten der Schichten (22, 23) Ohm'sche Elektroden (24, 25) aufgesetzt sind.

4. Bipolarer Heteroübergangszonentransistor, bestehend aus einem Substrat (31) aud $n^+$-Material, einer auf dem $n^+$-Substrat (31) angeordneten $n^-$-Kollektorschicht (32), einer auf der Kollektorschicht (32) angeordneten $p^+$-Basisschicht (33) sowie einer auf der Basisschicht (33) angeordneten n-Emitterschicht (34), dadurch gekennzeichnet, daß das Substrat (31), die Kollektorschicht (32) und die Basisschicht (33) jeweils aus InP bestehen, während die Emitterschicht (34) aus $Al_xIn_{1-x}As$ besteht, wobei x einen Zahlenwert von ungefähr 0,48 aufweist.

**Revendications**

1. Dispositif semi-conducteur, caractérisé par une hétérojonction entre une couche de InP et une couche de $Al_xIn_{1-x}As$ où x est à peu près égal à 0,48.

2. Transistor à effet de champ comprenant un substrat (11), deux électrodes ohmiques (16, 17) pour une source et un drain, et une électrode de Schottky (15) pour une porte, agencée entre les deux électrodes ohmiques (16, 17), caractérisé en ce que le substrat (11) comprend InP semi-isolant, en ce qu'une couche de InP non dopée est présente sur le substrat semi-isolant en InP, en ce qu'une couche de $In_{1-x}Al_xAs$ du type $N^+$ est présente sur la couche de InP, où x est à peu près égal à 0,48; et en ce que les deux électrodes ohmiques (16, 17) sont agencées en deux régions espacées sur la couche de $In_{1-x}Al_xAs$ du type $n^+$.

3. Dispositif semi-conducteur comprenant un substrat (21) et des électrodes ohmiques (24, 25) sur des côtés opposés du substrat, caractérisé en ce que le substrat (21) comprend InP semi-isolant, en ce que des couches empilées simples ou multiples de chacun de $Al_xIn_{1-x}As$ (22), où x est à peu près égal à 0,48, et InP (23) sont présentes sur le substrat isolant en InP (21) et en ce que les électrodes ohmiques (24, 25) sont placées sur des côtés opposés des couches (22, 23).

4. Transistor à hétérojonction bipolaire comprenant:

un substrat (31) du type $n^+$;

une couche de collecteur (32) du type $n^-$ sur le substrat (31) du type $n^+$;

une couche de base (33) du type $p^+$ sur la couche de collecteur (32); et

une couche d'émetteur (34) du type n disposée sur la couche de base (33),

caractérisé en ce que le substrat (31), la couche de collecteur (32) et la couche de base (33) comprennent InP et en ce que la couche d'émetteur (34) comprend $Al_xIn_{1-x}As$ où x est à peu près égal à 0,48.

Fig. 1A

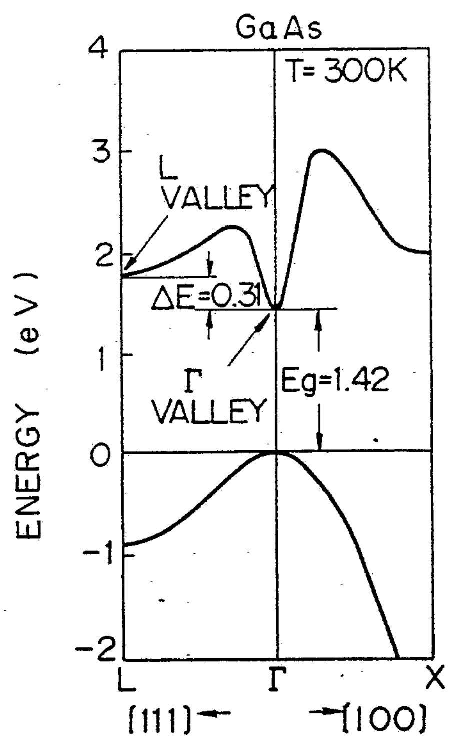


Fig. 1B

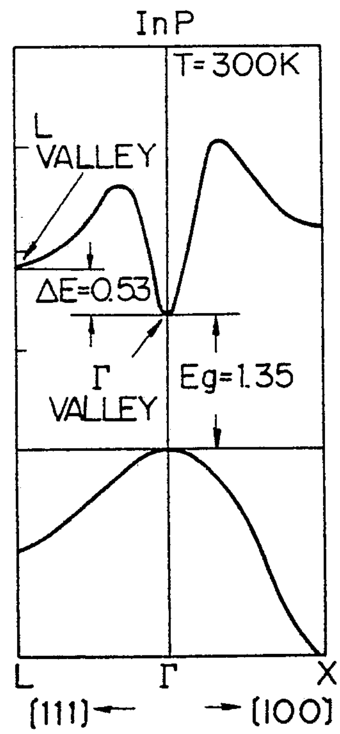


Fig. 2

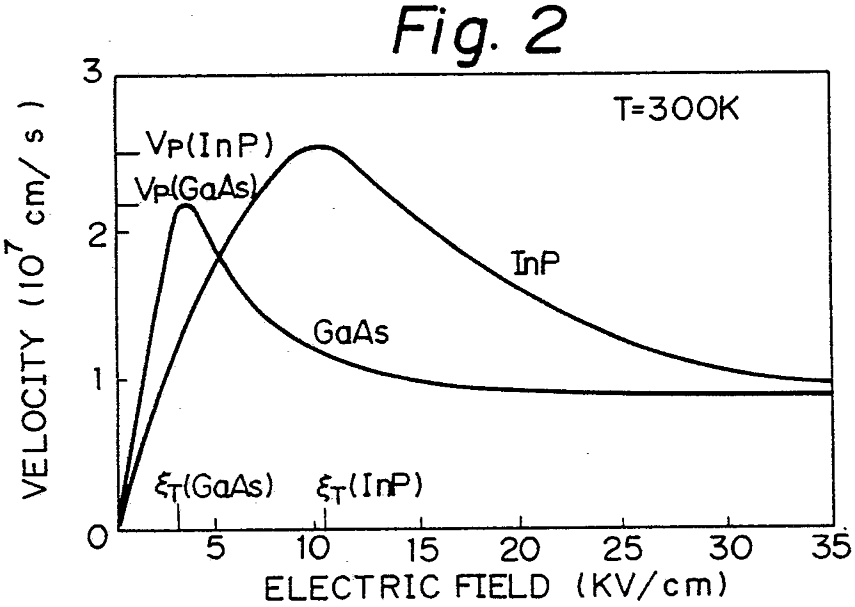

Fig. 3

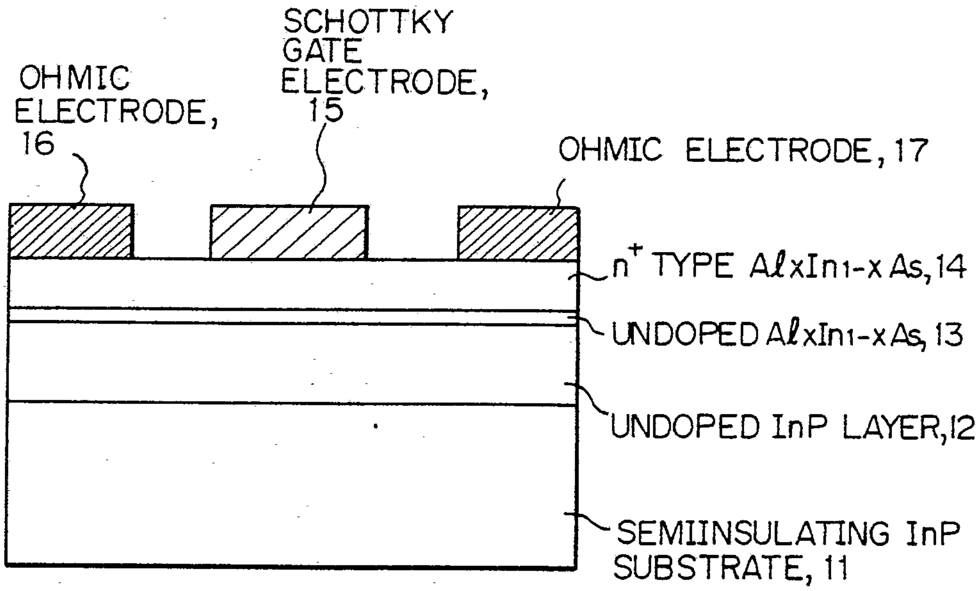
SCHOTTKY GATE ELECTRODE, 15
OHMIC ELECTRODE, 16
OHMIC ELECTRODE, 17
$n^+$ TYPE AlxIn1-xAs, 14
UNDOPED AlxIn1-xAs, 13
UNDOPED InP LAYER, 12
SEMIINSULATING InP SUBSTRATE, 11

Fig. 4

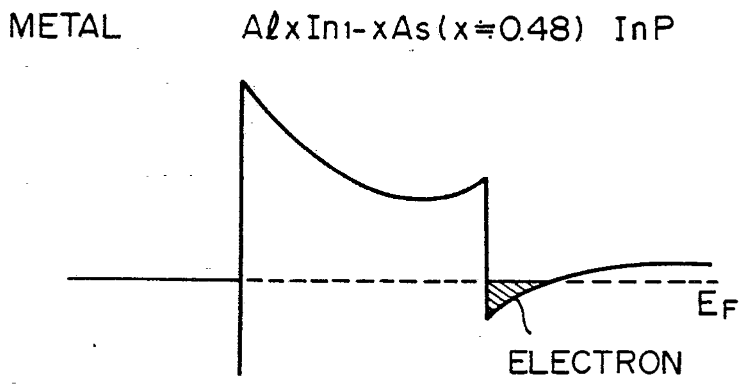
METAL
AlxIn1-xAs (x≒0.48)
InP
$E_F$
ELECTRON

Fig. 5

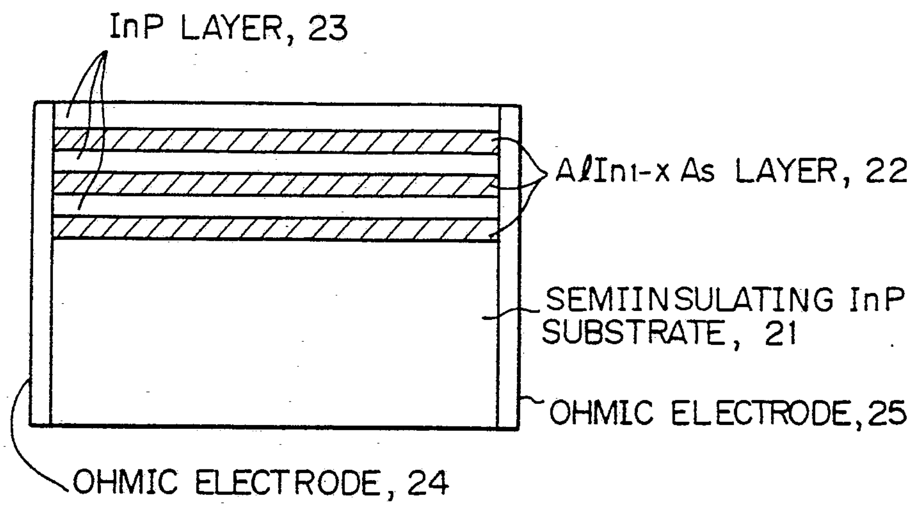
InP LAYER, 23
AlIn1-x As LAYER, 22
SEMIINSULATING InP SUBSTRATE, 21
OHMIC ELECTRODE, 25
OHMIC ELECTRODE, 24

Fig. 6

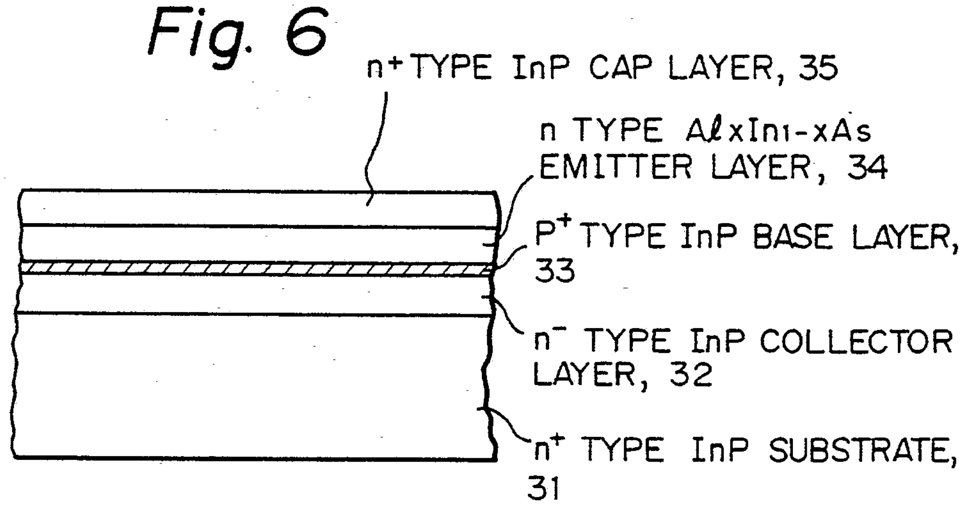
n+ TYPE InP CAP LAYER, 35
n TYPE AlxIn1-xAs EMITTER LAYER, 34
P+ TYPE InP BASE LAYER, 33
n- TYPE InP COLLECTOR LAYER, 32
n+ TYPE InP SUBSTRATE, 31